# EUROPEAN PATENT APPLICATION

(11) **EP 4 776 839 A1**
(43) Date of publication of application: **15.07.2026**
(21) Application number: 26150711.5
(22) Date of filing: 08.01.2026
(51) Int. Cl.: H10W 70/685, H10W 70/05, H05K 3/46, H10W 70/695, H10W 70/698, H10W 70/63, H10W 70/692

(54) **SYSTEMS AND METHODS FOR HIGH-STIFFNESS SUBSTRATE INTEGRATION IN SEMICONDUCTOR PACKAGES**

(30) Priority: 10.01.2025 US 202519016774
(71) Applicant: Avago Technologies International Sales Pte. Limited, Singapore 768923 (SG)
(72) Inventor: Theil, Jeremy Alfred, Mountain View, CA 94040 (US); Tendel, Shrikara Prabhu, 730726 Singapore (SG)
(74) Representative: Dilg, Haeusler, Schindelmann Patentanwaltsgesellschaft mbH

(57) **Abstract**

The subject technology is directed to semiconductor devices and fabrication methods thereof. In an embodiment, the subject technology provides an apparatus that includes a substrate comprising a first metal material and a first layer coupled to the substrate. The apparatus further includes a second layer coupled to the substrate via the first layer. The second layer comprises an organic material. The first layer includes a third layer comprising a first adhesion material configured to couple to the organic material, a fourth layer comprising a second adhesion material, and a fifth layer comprising a third adhesion material configured to couple to the first metal material. The multi-layer adhesion system enables reliable bonding between organic and metallic components, ensuring robust mechanical and electrical performance of the system. There are other embodiments as well.

## Description

### FIELD OF INVENTION

The subject technology is directed to semiconductor devices.

### BACKGROUND OF THE INVENTION

Semiconductor packages are essential components that provide both physical support and electrical connectivity for integrated circuits. They protect the circuits from environmental factors and facilitate the routing of electrical signals between the circuits and external systems. As electronic devices continue to evolve, there is a growing demand for semiconductor packages that can accommodate high-power applications and higher levels of integration. These applications often necessitate larger package sizes to house complex circuitry and multiple interconnected components, placing greater demands on the structural and thermal performance of the substrates used in these packages.

Some semiconductor packages may utilize organic or polymeric substrates due to their affordability and compatibility with standard manufacturing processes. However, these substrates typically lack the mechanical stiffness and thermal conductivity needed for advanced applications, particularly in large-scale packages. Warpage and mechanical instability can occur, especially when there are significant thermal stresses or mismatches in the coefficients of thermal expansion (CTE) between different materials in the package. Such mechanical instability can lead to misalignment of components and potential electrical failures.

Various approaches for mitigating warpage and improving the mechanical stability of semiconductor packages have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating a cross-sectional view of a semiconductor device according to embodiments of the subject technology.
Figures 2A- 2F are simplified diagrams illustrating a method for fabricating a semiconductor device according to embodiments of the subject technology.

### DETAILED DESCRIPTION OF THE INVENTION

The subject technology is directed to semiconductor devices and fabrication methods thereof. In an embodiment, the subject technology provides an apparatus that includes a substrate comprising a first metal material and a first layer coupled to the substrate. The apparatus further includes a second layer coupled to the substrate via the first layer. The second layer comprises an organic material. The first layer includes a third layer comprising a first adhesion material configured to couple to the organic material, a fourth layer comprising a second adhesion material, and a fifth layer comprising a third adhesion material configured to couple to the first metal material. The multi-layer adhesion system enables reliable bonding between organic and metallic components, ensuring robust mechanical and electrical performance of the system. There are other embodiments as well.

As previously noted, organic substrates are widely used in semiconductor packages to provide mechanical support and electrical connectivity. However, as packages become increasingly larger (e.g., exceeding 100 mm x 100 mm), these substrates exhibit significant limitations. For instance, their relatively low elastic modulus contributes to mechanical instability and warpage, with deformation levels exceeding 400 um in some cases. Warpage may arise from thermal stresses caused by mismatches in coefficients of thermal expansion (CTE) between different materials within the package, where CTE values can range from 3 to 36 ppm. These mechanical instabilities can lead to misalignment of components, unreliable electrical connections, and ultimately render the packages non-manufacturable.

Several approaches have been explored to address these challenges. For instance, some approaches involve the use of glass substrates, which have a higher elastic modulus (e.g., 50 GPa to 150 GPa). While glass substrates offer improved stiffness, they are prone to crosstalk between conductive traces due to their dielectric properties. Other approaches rely on metal substrates to improve mechanical stability and thermal conductivity. However, bonding organic materials to metal substrates presents significant challenges due to thermal expansion mismatches and differences in adhesion properties. These issues may result in delamination, cracking, and reduced reliability during thermal cycling or under mechanical stress. Moreover, the adoption of metal substrates introduces additional complexities, such as incompatibility with existing manufacturing processes and the need for advanced cooling techniques, making widespread implementation challenging.

In various embodiments, the subject technology provides semiconductor devices that integrate high-stiffness metal substrates using multi-layer adhesion systems. The adhesion system includes one or more layers designed to bond dissimilar materials, facilitating the integration of metal substrates with organic dielectric materials. The use of high-stiffness substrates in combination with the multi-layer adhesion system reduces warpage and enhances the mechanical stability of semiconductor packages, enabling the production of larger packages (e.g., exceeding 100 mm x 100 mm) without compromising manufacturability. The high elastic modulus of the metal substrate minimizes deformation under thermal and mechanical stresses, maintaining the alignment and reliability of package components. Additionally, the improved thermal conductivity of the metal substrate facilitates efficient heat dissipation, supporting the performance of high-power applications and preventing thermal-related failures.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising a substrate, which comprises a first metal material. The apparatus further comprises a first layer coupled to the substrate and a second layer coupled to the substrate via the first layer. The second layer comprises an organic material and configured to provide electrical connectivity to the substrate. The first layer is configured to couple the second layer to the substrate. The first layer comprises a third layer coupled to the second layer. The third layer comprises a first adhesion material configured to couple to the organic material. The first layer further comprises a fourth layer coupled to the third layer. The fourth layer comprises a second adhesion material.

Implementations may include one or more of the following features. The first layer further comprises a fifth layer coupled to the fourth layer and the substrate, the fifth layer comprises a third adhesion material configured to couple to the first metal material. The substrate is characterized by a first thickness, the fifth layer is characterized by a second thickness, and a ratio of the first thickness to the second thickness is greater than or equal to 10:1. The ratio of the first thickness to the second thickness is less than or equal to 5000:1. The third adhesion material comprises at least one of titanium nitride (TiN), tantalum nitride (TaN), titanium oxide (TiO₂), tantalum (Ta), or titanium tungsten nitride (TiWN). The substrate comprises a first via extending through the substrate, the first via comprises the first metal material. The substrate further comprises a sixth layer coupled to the first via, the sixth layer is configured to provide electrical isolation between the first via and the substrate. The first via is characterized by a first diameter, the fourth layer is characterized by a third thickness, and a ratio of the third thickness to the first diameter is less than or equal to 250:1. The first adhesion material comprises at least one of organosiloxane, hexamethyldisilazane (HMDS), or aminosilane. The second adhesion material comprises at least one of silicon oxide (SiO₂), silicon nitride (SiN), or silicon carbonitride (SiCN).

According to another embodiment, the subject technology provides an apparatus that comprises a substrate, which comprises a first metal material. The substrate comprises a first via extending through the substrate. The apparatus further comprises a first layer coupled to the substrate and a second layer coupled to the substrate via the first layer. The second layer comprises an organic material and configured to provide electrical connectivity to the substrate. The first layer is configured to couple the second layer to the substrate, the first layer comprises a third layer coupled to the second layer, and the third layer comprises a first adhesion material configured to couple to the organic material.

Implementations may include one or more of the following features. The first layer further comprises a fourth layer coupled to the third layer, the fourth layer comprises a second adhesion material, and the second adhesion material comprises at least one of silicon oxide (SiO₂), silicon nitride (SiN), or silicon carbonitride (SiCN). The first layer further comprises a fifth layer coupled to the fourth layer and the substrate, and the fifth layer comprises a third adhesion material configured to couple to the first metal material. The substrate is characterized by a first thickness, the fifth layer is characterized by a second thickness, and a ratio of the first thickness to the second thickness is greater than or equal to 10:1. The first via is characterized by a first diameter, the fourth layer is characterized by a third thickness, and a ratio of the third thickness to the first diameter is less than or equal to 250:1. The first adhesion material comprises at least one of organosiloxane, hexamethyldisilazane (HMDS), or aminosilane. The first metal material comprises at least one of molybdenum, copper, aluminum, tungsten, titanium, nickel, or vanadium.

According to yet another embodiment, the subject technology provides an apparatus, which comprises: a substrate comprising a first metal material; a first layer coupled to the substrate; and a second layer coupled to the substrate via the first layer. The second layer comprises an organic material and configured to provide electrical connectivity to the substrate. The first layer is configured to couple the second layer to the substrate, the first layer comprises
a third layer coupled to the second layer. The third layer comprises a first adhesion material configured to couple to the organic material. The first layer comprises a fourth layer coupled to the third layer, the fourth layer comprises a second adhesion material, and the fourth layer is configured to provide electrical isolation between the second layer and the substrate. In some embodiments, the first layer further comprises a fifth layer coupled to the fourth layer and the substrate, the substrate is characterized by a first thickness, the fifth layer is characterized by a second thickness, and a ratio of the first thickness to the second thickness is greater than or equal to 10:1. The substrate comprises a first via extending through the substrate, the first via is characterized by a first diameter, the fourth layer is characterized by a third thickness, and a ratio of the third thickness to the first diameter is less than or equal to 250:1. The first adhesion material comprises at least one of organosiloxane, hexamethyldisilazane (HMDS), or aminosilane.

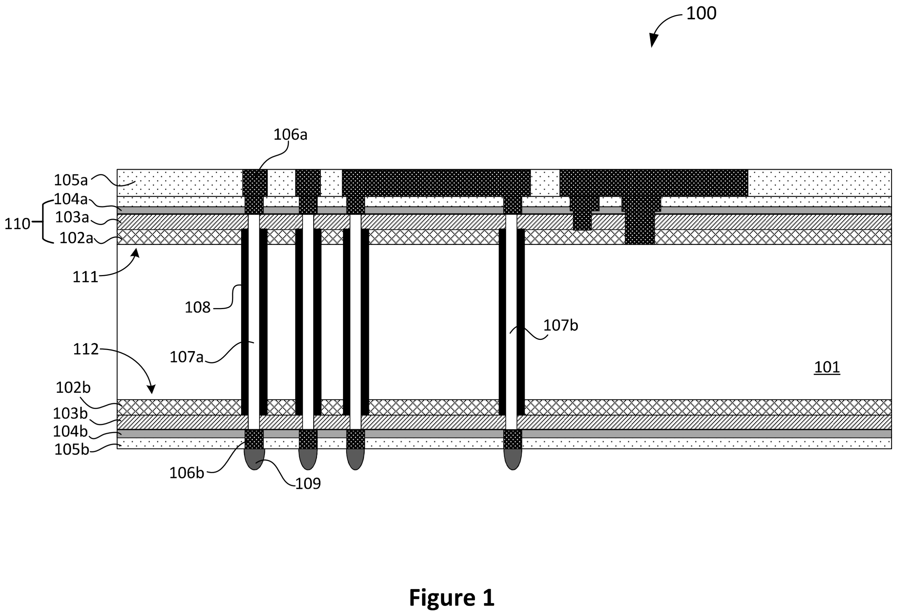

Figure 1 is a simplified diagram illustrating a cross-sectional view of semiconductor device 100 according to embodiments of the subject technology. This diagram merely provides an example, which should not unduly limit the scope of the claims. One of ordinary skill in the art would recognize many variations, alternatives, and modifications.

As shown, semiconductor device 100 includes substrate 101. For example, the term "substrate" may refer to a material or a structure that supports or carries other components or devices. Substrate 101 may be configured to provide mechanical support for other layers or components and form part of the electrical and thermal path in the device. Substrate 101 may be a package substrate, an interposer, a printed circuit board, and/or the like. Substrate 101 may include, without limitation, one or more materials such as metal, silicon, organic materials, ceramics, diamonds, or any combination thereof. In some examples, substrate 101 includes a first metal material. Metal material may include, without limitation, one or more materials such as molybdenum, copper, aluminum, tungsten, titanium, nickel, or alloys thereof.

In some embodiments, substrate 101 includes a high-stiffness metal substrate designed to reduce warpage and enhance the mechanical stability of large-scale semiconductor packages. For instance, the elastic modulus of substrate 101 may range from 100 GPa to 500 GPa, enabling it to resist deformation and maintain package reliability during thermal cycling or high-power operation. The use of a metal substrate with a high elastic modulus (e.g., molybdenum with approximately 300 GPa) allows substrate 101 to maintain alignment and structural integrity under thermal and mechanical stresses. Substrate 101 may be characterized by a thickness ranging from approximately 0.1 mm to 10 mm, depending on the application and design requirements.

In some cases, substrate 101 includes first side 111 and second side 112. First side 111 may be positioned opposite the second side 112. For purposes of this description, the first side may also be referred to as the top side, upper side, or upper surface. The second side may be referred to as the bottom side, lower side, underside, or backside. These terms are used interchangeably throughout this description to describe various embodiments and are not intended to limit the scope of the subject technology. In various implementations, both first side 111 and second side 112 of substrate 101 may include corresponding multi-layer structures that facilitate bonding, electrical connectivity, and thermal management within semiconductor device 100. For instance, the first side may include layers 102a, 103a, 104a, and 105a and connection 106a, while the second side may include corresponding layers 102b, 103b, 104b, and 105b and connection 106b. Depending on the implementation, these layers may be positioned on either side of substrate 101, facilitating the efficient integration of build-up layers and interconnects within semiconductor device 100

In various implementations, semiconductor device 100 further includes first layer 110 coupled to substrate 101. For instance, first layer 110 may be coupled to the first side of substrate 101. In some examples, second layer 105a may be coupled to substrate 101 via first layer 110. Second layer 105a may configured to provide electrical connectivity and signal transmission within semiconductor device 100. Second layer 105a may also contribute to the overall build-up structure of the semiconductor package, enabling additional functional layers and components to be integrated. Depending on the application, second layer 105a may be characterized by a thickness ranging from approximately 200 nm to 50 um.

In some embodiments, second layer 105a may include conductive pathways and interconnect structures, such as first connection 106a. For example, the term "connection" may refer to a conductive feature that facilitates electrical communication between different layers or components of the semiconductor device. Connections may include, without limitation, vias, conductive traces, pads, solder joints, and/or the like. In various examples, first connection 106a may comprise conductive materials such as copper, tungsten, or aluminum and may be configured to electrically couple second layer 105a to other components of semiconductor device 100, such as substrate 101 or external components.

In some embodiments, second layer 105a may further include an organic material configured to provide electrical insulation between the conductive pathways and interconnect structures within second layer 105a. Examples of organic materials may include, without limitation, Ajinomoto Build-Up Film (ABF), polyimide, epoxy resin, and/or the like. In some cases, the organic material may function as part of the build-up structure to support multi-layer interconnections and enable the integration of complex circuit pathways.

However, bonding an organic second layer (e.g., second layer 105a) to a metal substrate (e.g., substrate 101) presents significant challenges due to the differences in material properties. For example, mismatches in CTE between the organic material and the metal substrate can lead to mechanical instability during operation or thermal cycling, which may result in delamination, cracking, or warpage, ultimately affecting the reliability and performance of the semiconductor package. Moreover, organic materials typically exhibit poor adhesion to metallic surfaces, leading to weak interfaces and potential failure under mechanical or thermal stress.

To address these challenges, first layer 110 may serve as an adhesion layer that facilitates the bonding of second layer 105a to substrate 101. Depending on the implementation, first layer 110 may include one or more layers, each designed to bond dissimilar materials, facilitating the integration of metal substrates with organic materials. For instance, first layer 110 may include at least one of third layer 104a, fourth layer 103a, fifth layer 102a, and/or the like. The specific configuration of first layer 110 may vary based on design requirements and performance considerations. In some implementations, third layer 104a and/or fifth layer 102a may be optional. For example, first layer 110 may include fourth layer 103a or may include a combination of layers tailored to specific bonding, electrical, or thermal needs.

In some embodiments, third layer 104a is coupled to second layer 105a and includes a first adhesion material configured to bond effectively with the organic material of second layer 105a. Examples of first adhesion materials may include, without limitation, organosiloxane, hexamethyldisilazane (HMDS), aminosilane, polymeric bonding agents, and/or the like. These materials enhance the adhesion strength by interacting chemically or physically with the organic dielectric material of second layer 105a.

In various examples, fourth layer 103a may be coupled to third layer 104a and serves as an intermediate layer that provides electrical insulation and thermal stress management. For instance, fourth layer 103a is configured to provide electrical isolation between second layer 105a and substrate 101. In some examples, fourth layer 104a may include a second adhesion material. For instance, the second adhesion material may include silicon-based dielectric materials such as silicon oxide (SiO₂), silicon nitride (SiN), silicon carbonitride (SiCN), or alloys thereof. The second adhesion material ensures compatibility between the organic build-up layers (e.g., second layer 105a) and the substrate (e.g., substrate 101) by reducing stress concentrations at the interface and managing differences in CTE. In various embodiments, the first adhesion material of third layer 104a improves adhesion between the organic material of second layer 105a and the silicon-based dielectric material within fourth layer 103a, enabling smooth integration of the adhesion system. Depending on the implementation, third layer 104a may be characterized by a thickness ranging from as thin as a monolayer or sub-monolayer to several nanometers.

In some implementations, fifth layer 102a may be coupled to fourth layer 103a and substrate 101. Fifth layer 102a may be configured to interface with the first metal material of substrate 101, providing robust mechanical bonding between the build-up layers (e.g., second layer 105a) and the substrate (e.g., substrate 101). Fifth layer 102a may include a third adhesion material, which may be configured to be coupled to the first metal material. Examples of third adhesion materials may include, without limitation, titanium (Ti), titanium nitride (TiN), tantalum nitride (TaN), titanium oxide (TiO₂), tantalum (Ta), or titanium-tungsten nitride (TiWN). These materials provide strong adhesion to the metal substrate (e.g., substrate 101) through chemical and/or physical bonding mechanisms, such as chemical bonds or mechanical interlocking. The third adhesion material may be designed to permit good adhesion between the metallic substrate and the silicon-based dielectric material in fourth layer 103a, ensuring compatibility across the adhesion system. Depending on the implementation, fifth layer 102a may function as a conductor to provide a conductive pathway for electrical signals or an insulator to ensure reliable electrical isolation.

In various embodiments, the thickness of substrate 101 is characterized by a first thickness, and the thickness of fifth layer 102a is characterized by a second thickness. In some examples, the ratio of the first thickness to the second thickness may be greater than or equal to 10:1 and/or less than or equal to 5000:1. For instance, the ratio may range from 10:1 to 50:1, 100:1 to 500:1, or 1000:1 to 3000:1. This ensures that substrate 101 provides sufficient structural support and thermal conductivity, while fifth layer 102a remains thin enough to maintain efficient bonding without adding excessive bulk to the overall package.

According to some embodiments, substrate 101 may include one or more vias (e.g., first via 107a, second via 107b, etc.). For instance, the term "via" may refer to a conductive pathway that connects different layers of a substrate. These vias may be configured to provide various functions including, without limitation, vertical interconnection, signal transmission, power distribution, heat dissipation, mechanical support, or the like. These vias enable vertical electrical or thermal connectivity, ensuring efficient signal transmission and heat dissipation across multiple layers. A via may include conductive materials such as molybdenum, copper, aluminum, tungsten, titanium, nickel, or alloys thereof.

In some examples, first via 107a and/or second via 107b may extend vertically through substrate 101, facilitating connectivity between the build-up layers (e.g., second layer 105a) and external components. For instance, first via 107a may be coupled to first connection 106a, which is configured to transmit electrical signals or power to external circuitry or devices. These vias enable vertical electrical or thermal connectivity, ensuring efficient signal transmission and heat dissipation across multiple layers.

Depending on the implementation, the material composition of the vias may match or differ from the material of substrate 101. For example, first via 107a may include the first metal material (e.g., molybdenum, copper, or aluminum), which ensures compatibility with the substrate in terms of thermal expansion and electrical conductivity. In some cases, second via 107b may include a second metal material different from the first metal material. This is beneficial for adjusting the effective CTE of substrate 101, reducing stress at the interface during thermal cycling. Additionally, varying the material composition allows for the optimization of electrical resistance in the vias, enabling the design to accommodate specific performance requirements, such as minimizing signal loss in high-frequency applications or managing power dissipation in high-current pathways.

In various embodiments, first via 107a is characterized by a first diameter, fourth layer 103a is characterized by a third thickness. The ratio of the first diameter to the third thickness may be greater than or equal to 1:1 and/or less than or equal to 250:1. This ensures that the via has sufficient cross-sectional area to conduct electrical signals or dissipate heat effectively, while the thickness of fourth layer 103a provides adequate electrical isolation and mechanical stress distribution. Additionally, the diameter of the vias may vary depending on the implementation. For instance, first via 107a may have a larger diameter to support high-current power delivery, while second via 107b may have a smaller diameter optimized for signal routing.

To ensure proper electrical insulation and mechanical stability, substrate 101 may further include an insulating layer (e.g., sixth layer 108) coupled to first via 107a. Sixth layer 108 may surround first via 107a to electrically isolate it from adjacent conductive structures within substrate 101. In some examples, sixth layer 108 may include materials such as silicon dioxide, silicon nitride, or other dielectric materials. Sixth layer 108 may act as a barrier, preventing electrical shorts between the conductive via and the substrate material. Additionally, sixth layer 108 may provide mechanical support for the via (e.g., first via 107a), distributing stress caused by thermal cycling. In high-power applications, sixth layer 108 may also function as a thermal barrier, managing heat flow between substrate 101 and via 107a to maintain optimal device performance.

In various implementations, second side 112 of substrate 101 may include a structure that mirrors the multi-layer arrangement on first side 111, including layers such as second layer 105b, third layer 104b, fourth layer 103b, and fifth layer 102b. These layers collectively form part of the dual-sided adhesion and build-up system, enabling electrical connectivity, thermal management, and mechanical stability on both sides of substrate 101. In some embodiments, semiconductor device 100 further includes interconnect 109. For instance, the term "interconnect" may refer to a structure or mechanism that electrically connects two or more layers or components in a semiconductor device. Interconnect 109 may include, without limitation, metal traces, solder bumps, conductive adhesives, wire bonds, ball grid array (BGA), and/or the like. In some cases, interconnect 109 may be coupled to second layer 105b, facilitating the connection between second layer 105b and other components within the package (e.g., ground planes or external structures).

It is to be appreciated that semiconductor device 100 incorporates a high-stiffness substrate and multi-layer adhesion system, enabling reliable bonding and mechanical stability in large-scale semiconductor packages. The use of a high-stiffness substrate minimizes warpage, ensuring structural integrity and alignment during thermal cycling and under mechanical stress.

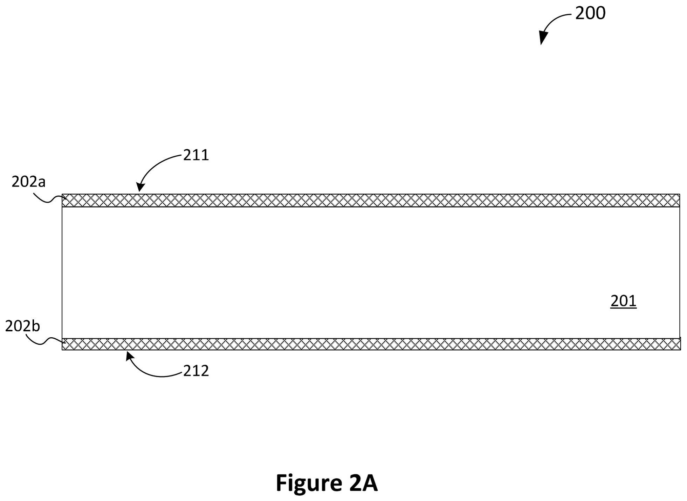

Figures 2A- 2F are simplified diagrams illustrating method 200 for fabricating a semiconductor device according to embodiments of the subject technology. These diagrams merely provide an example, which should not unduly limit the scope of the claims. One of ordinary skill in the art would recognize many variations, alternatives, and modifications.

In various implementations, method 200 may be used to fabricate semiconductor devices, such as semiconductor device 100 illustrated in Figure 1, which can be applied across a wide range of applications, including high-power electronics, large-scale packages, high-density integrated circuits, and/or the like. In some embodiments, method 200 may incorporate a high-stiffness substrate to minimize warpage and deformation under thermal and mechanical stresses. The method may also employ a multi-layer adhesion system to facilitate bonding between dissimilar materials, such as metallic substrates and organic dielectric layers, to ensure reliable mechanical stability and electrical connectivity throughout the device.

As shown in Figure 2A, method 200 begins with the preparation of substrate 201. Substrate 201 may include a high-stiffness metal substrate designed to reduce warpage and enhance the mechanical stability of large-scale semiconductor packages. For instance, substrate 201 includes a first metal material, which may include, without limitation, one or more materials such as molybdenum, copper, aluminum, tungsten, titanium, nickel, or alloys thereof. Substrate 201 includes first side 211 and second side 212, each of which can support a multi-layer structure for bonding, signal routing, and thermal management. In some cases, substrate 201 may be mounted onto a carrier using a temporary bonding adhesive to stabilize it during subsequent fabrication steps.

In some implementations, an adhesion layer (e.g., first layer 110 of Figure 1) may be deposited onto one or both sides of substrate 101 to facilitate the bonding of subsequent build-up layers. Depending on the implementation, the adhesion layer may include one or more layers. For instance, fifth layers 202a and 202b may be deposited on first side 211 and second side 212 of substrate 201, respectively. These layers may include a third adhesion material, such as titanium (Ti), titanium nitride (TiN), tantalum nitride (TaN), titanium oxide (TiO₂), tantalum (Ta), or titanium-tungsten nitride (TiWN). These materials bond effectively with the metallic surface of the substrate through chemical and/or physical bonding mechanisms, providing robust adhesion between substrate 101 and subsequent layers.

The deposition of fifth layers 202a and 202b may be performed using various techniques, such as physical vapor deposition (PVD), chemical vapor deposition (CVD), atomic layer deposition (ALD), sputtering, and/or the like. In some cases, it may be desirable to prepare the surfaces of substrate 101 before beginning the deposition process. For example, the preparation may include surface polishing or planarization to remove irregularities and create a smooth surface. Polishing may be performed using hot rolling, mechanical polishing, chemical-mechanical planarization (CMP), or other abrasive techniques.

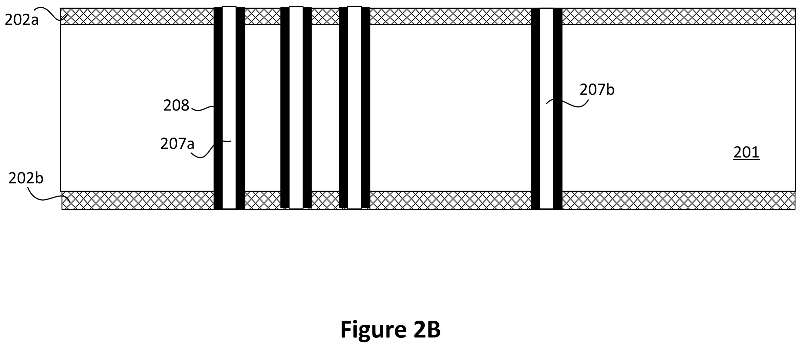

In various embodiments, as shown in Figure 2B, one or more vias (e.g., first via 207a and second via 207b) may be formed in substrate 201. For instance, these vias are etched through the substrate material to create vertical pathways that enable electrical and thermal connectivity between the multi-layer structures on the first and second sides of substrate 201. Depending on the material of the substrate and the desired properties of the via, first via 207a and second via 207b may be formed using various techniques including, without limitation, laser drilling, mechanical drilling, chemical etching, mold sintering, 3D printing, or the like. In some cases, photolithography may be employed to define precise patterns on the surface of substrate 201.

After etching the vias, a liner oxide may be deposited to coat the inner surfaces of the vias. For instance, sixth layer 208 may be coupled to first via 207a to provide electrical insulation and prevent direct contact between the conductive material to be filled later and the substrate material. In some examples, sixth layer 108 may include materials such as silicon dioxide, silicon nitride, or other dielectric materials. The deposition of sixth layer 208 may be performed using various techniques, such as spin-on coating, plasma-enhanced chemical vapor deposition (PECVD), sub-atmospheric chemical vapor deposition (SACVD), photolithography, dry etching, and/or the like. The number and configuration of the vias may depend on the specific implementation. For example, first via 207a and second via 207b may include different geometries such as straight, sloped, angled, curved, or stepped sidewalls.

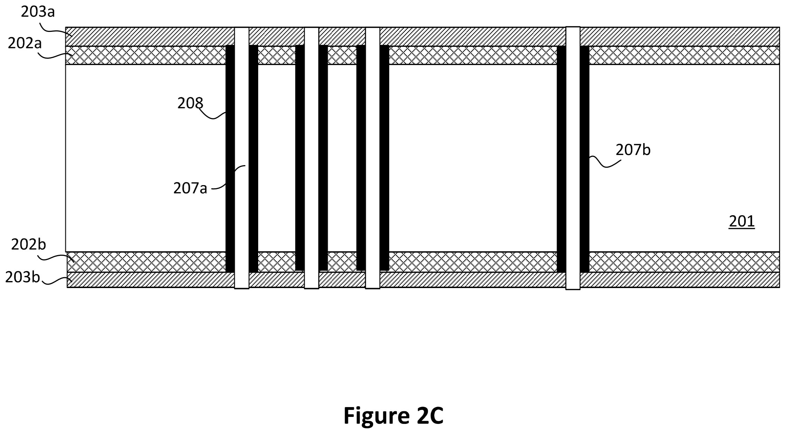

As shown in Figure 2C, method 200 further includes the deposition of fourth layers 203a and 203b. For instance, fourth layers 203a and 203b may be coupled to fifth layers 202a and 202b, respectively. Fourth layers 203a and 203b may include a second adhesion material. For instance, the second adhesion material may include silicon-based dielectric material, such as silicon oxide (SiO₂), silicon nitride (SiN), silicon carbonitride (SiCN), or alloys thereof. Fourth layers 203a and 203b may be configured to provide electrical insulation, thermal stress management, and bonding between substrate 201 and subsequent build-up layers. The deposition of fourth layers 203a and 203b may be performed using techniques such as PECVD, PVD, photolithography, dry etching, wet etching, and/or the like. In some examples, fourth layers 203a and 203b may be characterized by a thickness ranging from 20 nm to 5 um.

In some embodiments, if fourth layers 203a and 203b are sufficiently thin, they may partially coat the inner surfaces of the vias lined with the oxide layer (e.g., sixth layer 208). This allows direct contact between the silicon-based dielectric adhesion layer and the liner oxide, eliminating the need for additional patterning. Alternatively, the vias may be etched after the deposition of adhesion layers (e.g., fourth layers 203a-b and/or fifth layers 202a-b) on both sides of substrate 201 to ensure uniform coverage and robust adhesion across all interfaces.

Following the deposition of fourth layers 203a-b, the vias may be filled with a conductive material (e.g., copper, tungsten, titanium, aluminum, gold, silver, tin, nickel, lead, or the like) to ensure electrical conductivity and structural integrity. The filling process may be performed using various techniques, such as electroplating, electroless plating, CVD, PVD, and/or the like. In some cases, a seed layer may first be deposited using sputtering or CVD to facilitate uniform deposition of the conductive material. Depending on the implementation, the material composition of the vias may match or differ from the material of substrate 201. For example, first via 207a may include the first metal material while the second via 207b may include a second metal material different from the first metal material. In some cases, excess materials deposited during this process are subsequently removed using techniques such as CMP or etching to ensure a smooth and uniform surface for further processing.

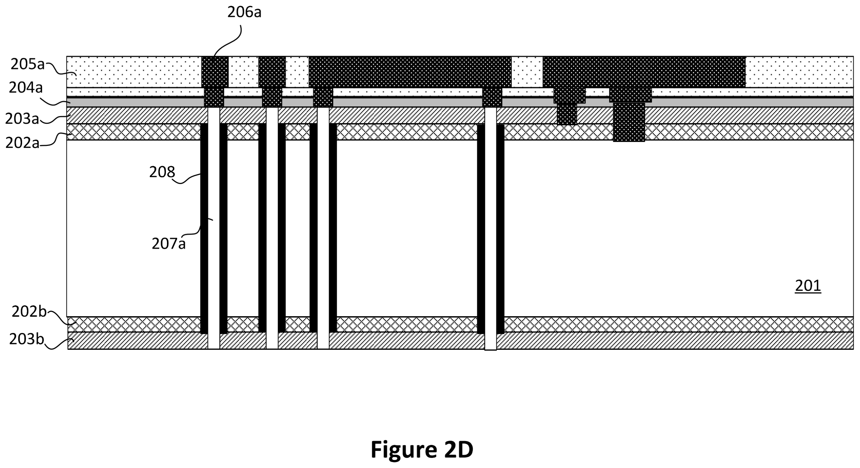

As shown in Figure 2D, method 200 further includes the deposition of third layer 204a. For instance, third layer 204a may be deposited on first side 211 and coupled to fourth layer 203a. In some embodiments, third layer 204a serves as an adhesion interface between the silicon-based dielectric layer (e.g., fourth layer 203a) and the subsequent build-up layers. For instance, third layer 204a may include a first adhesion material, which is configured to bond effectively with organic materials. Examples of first adhesion materials may include, without limitation, organosiloxane, hexamethyldisilazane (HMDS), aminosilane, polymeric bonding agents, and/or the like. Deposition of the third layer 204a may be performed using techniques such as spin-on coating, vapor priming, CVD, PECVD, and/or the like. Depending on the implementation, third layer 204a may be characterized by a thickness ranging from as thin as a monolayer or sub-monolayer to several nanometers.

Following the deposition of the third layer 204a, one or more build-up layers may be formed to enable routing, insulation, and thermal management. For instance, second layer 205a may be deposited onto first side 211 and coupled to third layer 204a. Deposition of the second layer 205a may be performed using techniques such as spin-on coating, lamination, CVD, and/or the like. Depending on the design and application, second layer 205a may be characterized by a thickness ranging from approximately 200 nm to 50 um. In some examples, second layer 205a may include an organic material configured to provide electrical insulation between the conductive pathways and interconnect structures within second layer 205a. Examples of organic materials may include, without limitation, Ajinomoto Build-Up Film (ABF), polyimide, epoxy resin, and/or the like.

In some embodiments, the organic material may function as part of the build-up structure to support multi-layer interconnections and enable the integration of complex circuit pathways. For instance, first connection 206a may be formed in second layer 205a to establish electrical pathways between different layers or components of the semiconductor device. First connection 206a may include conductive features such as vias, conductive traces, pads, solder joints, and/or the like. First connection 206a may include conductive materials such as copper, tungsten, aluminum, and/or the like. In various implementations, the formation of first connection 206a may involve processes such as electroplating, sputtering, or PVD, followed by photolithography and etching to define precise geometries.

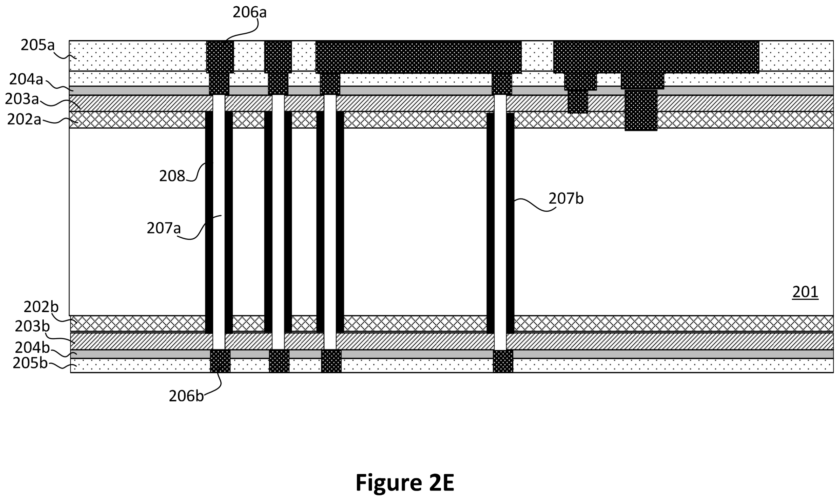

Similarly, as shown in Figure 2E, third layer 204b and second layer 205b may be formed on second side 212 of substrate 201. For instance, third layer 204b may act as an adhesion layer, facilitating strong bonding between fourth layer 203b and the subsequent build-up layers (e.g., second layer 205b). In some examples, second connection 206b may be formed within second layer 205b to enable electrical pathways on second side 212.

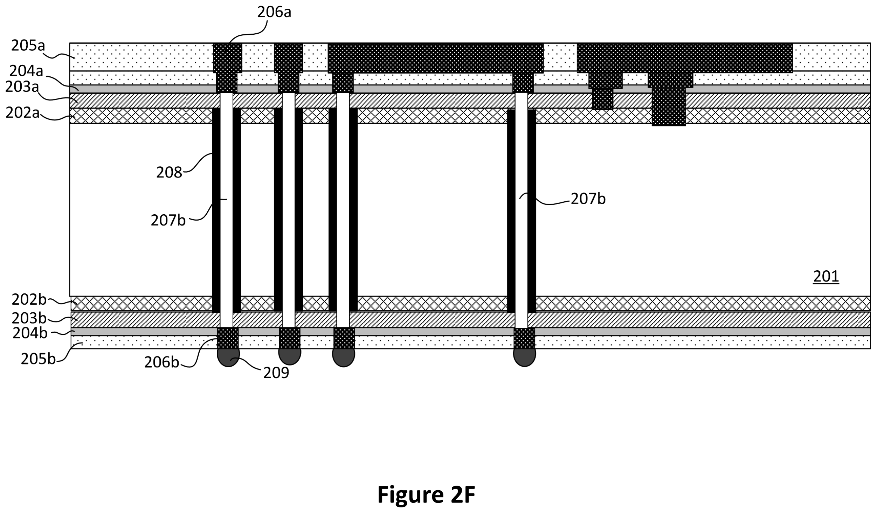

As shown in Figure 2F, method 200 further includes the formation of interconnect 209, which may be configured to couple substrate 201 to external components. Interconnect 209 may include, without limitation, metal traces, solder bumps, conductive adhesives, wire bonds, ball grid array (BGA), and/or the like. In some examples, interconnect 209 may include conductive materials such as copper, aluminum, gold, silver, solder alloys (e.g., tin-lead or lead-free alloys), and/or the like. The formation of interconnect 209 may involve various techniques such as thermal compression bonding, solder reflow, electroplating, and/or the like.

Method 200 incorporates the use of high-stiffness substrates and a multi-layer adhesion system, enabling reliable bonding and electrical connectivity between dissimilar materials such as metal and organic dielectrics. These features enhance mechanical stability and minimize warpage, making the method well-suited for large-scale semiconductor packages and high-density applications. Additionally, the compatibility of the process with standard fabrication techniques, such as PECVD, PVD, and electroplating, supports efficient integration into existing manufacturing workflows, facilitating wide adoption across various applications.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising:
a substrate comprising a first metal material;
a first layer coupled to the substrate; and
a second layer coupled to the substrate via the first layer, the second layer comprising an organic material and configured to provide electrical connectivity to the substrate; wherein the first layer is configured to couple the second layer to the substrate, the first layer comprises:
a third layer coupled to the second layer, and the third layer comprises a first adhesion material configured to couple to the organic material.

2. The apparatus of claim 1, wherein:
the first layer comprises:
a fourth layer coupled to the third layer, the fourth layer comprises a second adhesion material.

3. The apparatus of claim 1 or 2, wherein:
the first layer further comprises a fifth layer coupled to the fourth layer and the substrate, the fifth layer comprises a third adhesion material configured to couple to the first metal material.

4. The apparatus of any one of the preceding claims, wherein:
the substrate is **characterized by** a first thickness, the fifth layer is **characterized by** a second thickness, and a ratio of the first thickness to the second thickness is greater than or equal to 10:1.

5. The apparatus of claim 4, wherein
the ratio of the first thickness to the second thickness is less than or equal to 5000:1.

6. The apparatus of claim 3, wherein
the third adhesion material comprises at least one of titanium nitride (TiN), tantalum nitride (TaN), titanium oxide (TiO₂), tantalum (Ta), or titanium tungsten nitride (TiWN).

7. The apparatus of any one of the preceding claims, wherein
the substrate comprises a first via extending through the substrate,
wherein in particular
the first via comprises the first metal material.

8. The apparatus of claim 7, wherein
the substrate further comprises a sixth layer coupled to the first via, the sixth layer is configured to provide electrical isolation between the first via and the substrate.

9. The apparatus of claim 7 or 8, wherein
the first via is **characterized by** a first diameter, the fourth layer is **characterized by** a third thickness, and a ratio of the third thickness to the first diameter is less than or equal to 250:1.

10. The apparatus of any one of the preceding claims, wherein
the first adhesion material comprises at least one of organosiloxane, hexamethyldisilazane (HMDS), or aminosilane.

11. The apparatus of any one of the preceding claims, wherein
the second adhesion material comprises at least one of silicon oxide (SiO₂), silicon nitride (SiN), or silicon carbonitride (SiCN).

12. The apparatus of any one of the preceding claims, wherein
the first metal material comprises at least one of molybdenum, copper, aluminum, tungsten, titanium, nickel, or vanadium.

13. An apparatus of any one of the preceding claims, wherein
the fourth layer being configured to provide electrical isolation between the second layer and the substrate.
